# EUROPÄISCHE PATENTSCHRIFT

(11) **EP 2 034 807 B1**
(45) Veröffentlichungstag und Bekanntmachung des Hinweises auf die Patenterteilung: **04.01.2017**
(21) Anmeldenummer: 08105191.4
(22) Anmeldetag: 01.09.2008
(51) Int. Cl.: H05K 1/14, H05K 3/36

(54) **Leiterplattenstapel aus löttechnisch miteinander verbundenen Leiterplatten**
Circuit board stack comprised of circuit boards soldered to each other
Pile de plaquettes constituée de plaquettes reliées ensemble par la technique de soudure

(30) Priorität: 04.09.2007 DE 102007041770
(43) Veröffentlichungstag der Anmeldung: 11.03.2009
(73) Patentinhaber: Continental Automotive GmbH, 30165 Hannover (DE)
(72) Erfinder: Wolf, Peter, 78078 Niedereschach (DE)

(56) Entgegenhaltungen:
- EP-A- 0 074 816
- DE-A1- 3 316 017
- FR-A- 2 724 051
- US-A- 6 076 726
- US-A1- 2006 203 459

## Beschreibung

Die Erfindung betrifft einen Leiterplattenstapel aus drei übereinander und parallel zueinander angeordneten Leiterplatten, die mittels einer Lötverbindung miteinander elektrisch leitend und mechanisch verbunden sind.

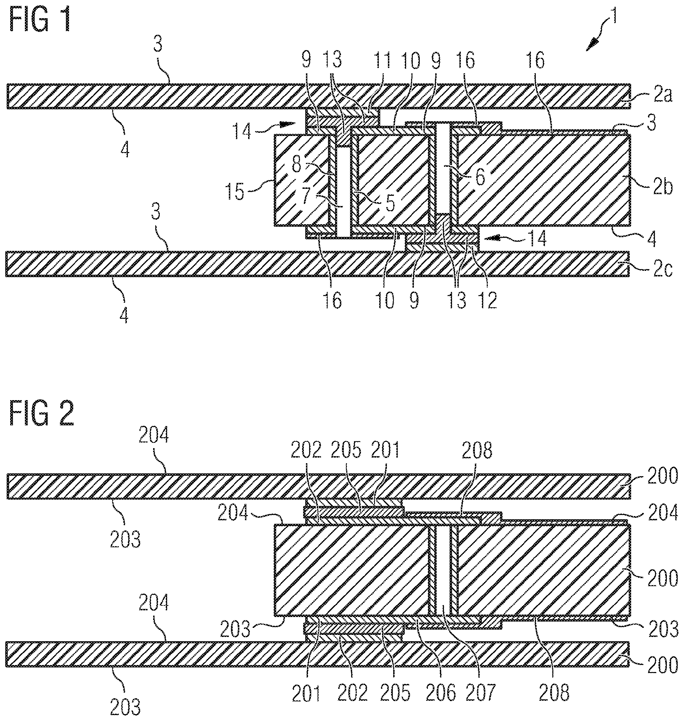

Es ist bekannt, mehrere übereinander und parallel zueinander angeordnete Leiterplatten 200 derart miteinander löttechnisch zu verbinden, dass die Leiterplatten 200 im Bereich von einfachen, durchgehenden Lötpads 201, 202 miteinander verlötet sind (Fig. 2). Dazu weist die jeweils obere Leiterplatte 200 an ihrer Leiterplattenunterseite 203 ein oberes Lötpad 201 auf, und die jeweils untere Leiterplatte 200 weist an ihrer der oberen Leiterplatte 200 zugewandten Leiterplattenoberseite 204 ein unteres Lötpad 202 auf. Die beiden Leiterplatten 200 sind dabei so angeordnet bzw. positioniert, dass die beiden Lötpads 201, 202 übereinander bzw. in einer Richtung senkrecht zur Erstreckung der Leiterplatten 200 zueinander fluchtend angeordnet sind. Die Verbindung der beiden Leiterplatten 200 erfolgt beispielsweise durch Aufbringen von Lot 205, z. B. Lötzinn, auf das untere Lötpad 202, anschließendes Positionieren der oberen Leiterplatte 200 und Zusammenpressen der beiden Leiterplatten 200. Die beiden Lötpads 201, 202 sind dann löttechnisch miteinander verbunden. Das Verlöten der beiden sich gegenüberliegenden flachen Flächen erfolgt dabei ohne die bekannte Meniskusbildung. Von den Lötpads 201, 202 führen in an sich bekannter Weise Leiterbahnen 206 weg, z. B. zu Durchkontaktierungen 207. Zudem ist Lötstoplack 208 auf die Leiterbahnen 206 aufgebracht.

Schwierig bei dieser Verbindungsart ist, die richtige und vor allem ausreichende Menge an Lot 205 zu verwenden. Denn bei Verwendung von zu viel Lot 205 besteht die Gefahr, dass das Lot 205 zwischen den Leiterplatten 200 verläuft, was zu Kurzschlüssen mit anderen Verbindungen führen kann. Und bei Verwendung von zu wenig Lot 205 und eine damit notwendige starke Verpressung entsteht eine schlechte, dünne und damit leicht brechende Lötverbindung.

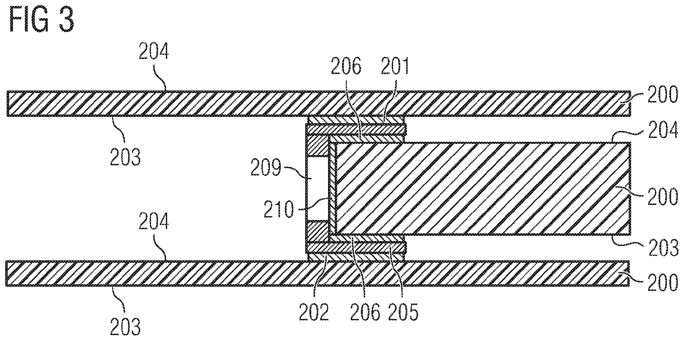

Um diese Probleme zu lösen, ist es bekannt, bei einer der beiden miteinander zu verbindenden Leiterplatten 200 anstelle der Lötpads 201, 202 eine halboffene, halbzylindrische Durchkontaktierung 209 vorzusehen und das Lötpad 201, 202 der einen Leiterplatte 200 mit der halboffenen Durchkontaktierung 209 der anderen Leiterplatte 200 löttechnisch zu verbinden (Fig. 3). Bei dieser Verbindungsart ist von Vorteil, dass das überschüssige Lot 205 in die halboffene Durchkontaktierung 209 hinein fließt und es somit zu keinem Kurzschluss mit anderen Verbindungen kommt. Allerdings ist die Herstellung der halboffenen Durchkontaktierung 209 aufwendig. Denn dazu muss zunächst im Kantenbereich der Leiterplatte 200 eine normale, geschlossene Durchkontaktierung 207 hergestellt werden und diese anschließend in einem zusätzlichen Verfahrensschritt wieder aufgefräst werden. Zudem muss das Auffräsen von beiden Leiterplattenseiten 203, 204 her erfolgen, da ansonsten eine Metallbeschichtung bzw. Metallisierung 210 der Durchkontaktierung 209 ausfranst. Außerdem muss die Verbindung der beiden Leiterplatten 200 zwangsweise im Kantenbereich der die halboffene Durchkontaktierung 209 aufweisenden Leiterplatte 200 erfolgen.

Des Weiteren ist es aus der US 6,076,726 A bekannt, nach der sogenannten "Via-in-Pad"-Technologie Durchkontaktierungen in einem Lötpad vorzusehen und an Lötpads elektrische Bauteile, insbesondere BGAs (Ball Grid Array) elektrisch leitend anzubinden. Die US 6,076,726 A offenbart dazu zwei verschiedene Möglichkeiten zur Anbindung von BGAs an die Lötpads. Um zu verhindern, dass beim Verlöten das gesamte Lot aufgrund von Kapillarkräften in die Durchkontaktierung hinein gezogen wird, wird gemäß der US 6,076,726 A zunächst die Durchkontaktierung mit einem anderen Material als dem Lotmaterial, das bei Löttemperatur stabil ist, verstopft und anschließend das Lot darauf aufgebracht und verlötet. Nach einer anderen in der US 6,076,726 A offenbarten Verbindungsmöglichkeit wird die Durchkontaktierung mit einem Material beschichtet, das abstoßend auf das Lotmaterial wirkt und nicht von diesem benetzt wird. Das Verlöten der BGAs an die Lötpads erfolgt dabei mit der bekannten Meniskusbildung, so dass diese Art des Verlötens nicht mit dem Verlöten und gleichzeitigen Verpressen von flachen Flächen wie in den vorangegangenen Beispielen vergleichbar ist.

DE 3316017 A1 offenbart einen Leiterplattenstapel bestehend aus drei parallel zueinander übereinander angeordneten Leiterplatten.

Aufgabe der Erfindung ist die Bereitstellung eines Leiterplattenstapels aus zumindest zwei übereinander und parallel zueinander angeordneten, miteinander elektrisch und mechanisch löttechnisch miteinander verbundenen Leiterplatten, der einfach und kostengünstig herstellbar ist und eine sichere löttechnische Verbindung der Leiterplatten gewährleistet.

Diese Aufgabe wird durch die Merkmale des Anspruchs 1 gelöst. Vorteilhafte Weiterbildungen der Erfindung sind in den Unteransprüchen gekennzeichnet.

Gemäß der Erfindung besteht der erfindungsgemäße Leiterplattenstapel aus drei parallel zueinander und zumindest bereichsweise übereinander angeordneten Leiterplatten, nämlich einer oberen Leiterplatte, einer unteren Leiterplatte und einer zwischen diesen angeordneten mittleren Leiterplatte, wobei jeweils zwei benachbarte Leiterplatten mittels zumindest einer Lötverbindung miteinander elektrisch und mechanisch in Verbindung stehen. Die mittlere Leiterplatte weist eine erste und eine zweite durchgehende Durchkontaktierung auf, wobei die Lötverbindung zwischen der oberen Leiterplatte und der mittleren Leiterplatte zwischen einer auf einer Leiterplattenunterseite der oberen Leiterplatte vorgesehenen Metallbeschichtung und der ersten durchgehenden Durchkontaktierung der mittleren Leiterplatte und die Lötverbindung zwischen der unteren Leiterplatte und der mittleren Leiterplatte zwischen einer auf einer Leiterplattenoberoberseite der unteren Leiterplatte vorgesehenen Metallbeschichtung und der zweiten durchgehenden Durchkontaktierung der mittleren Leiterplatte besteht. Die beiden Durchkontaktierungen sind zu einer der Lötverbindung gegenüberliegenden Leiterplattenseite der mittleren Leiterplatte hin jeweils offen. Es handelt sich bei den Metallbeschichtungen um ein Durchkontaktierungspad einer als innenseitig metallisiertes Sackloch ausgeführten Durchkontaktierung oder eine Leiterbahn oder ein durchgehendes, nicht durch eine Durchkontaktierung unterbrochenes Pad.

Insbesondere sind das Pad der ersten Leiterplatte und die Durchkontaktierung mittels dazwischen vorgesehenem Lot miteinander verlötet.

Zudem sind das Pad der ersten Leiterplatte und die Durchkontaktierung zweckmäßigerweise in einer Richtung senkrecht zur flächenmäßigen Erstreckung der Leiterplatten zueinander fluchtend und sich gegenüberliegend angeordnet.

Im Folgenden wird die Erfindung anhand der Zeichnung beispielhaft näher erläutert. Es zeigen
- Figur 1:: Schematisch einen Schnitt durch einen erfindungsgemäßen Leiterplattenstapel senkrecht zur Erstreckung von Leiterplatten des erfindungsgemäßen Leiterplattenstapels im Bereich der löttechnischen Verbindung,
- Figur 2:: Schematisch einen Schnitt analog zu Fig. 1 durch einen Leiterplattenstapel gemäß dem Stand der Technik senkrecht zur Erstreckung der Leiterplatten des Leiterplattenstapels im Bereich der löttechnischen Verbindung,
- Figur 3:: Schematisch einen Schnitt analog zu Fig. 1 durch einen Leiterplattenstapel gemäß einem weiteren Stand der Technik senkrecht zur Erstreckung der Leiterplatten des Leiterplattenstapels im Bereich der löttechnischen Verbindung.

Der erfindungsgemäße Leiterplattenstapel bzw. das erfindungsgemäße Leiterplattenmodul 1 besteht aus drei Leiterplatten 2a, 2b, 2c (Fig. 1). Die Leiterplatten 2a, 2b, 2c sind parallel zueinander und zumindest bereichsweise übereinander bzw. in einer Richtung senkrecht zur flächenmäßigen Erstreckung der Leiterplatten 2a, 2b, 2c zumindest bereichsweise fluchtend zueinander angeordnet. Außerdem sind die Leiterplatten 2a, 2b, 2c vorzugsweise quaderförmig ausgebildet und weisen je eine Leiterplattenoberseite 3 und eine dazu parallele Leiterplattenunterseite 4 sowie zweckmäßigerweise vier paarweise zueinander und zur Leiterplattenoberseite 3 senkrechte Leiterplattenseitenkanten 15 auf. Zweckmäßigerweise sind die Leiterplatten 2a, 2b, 2c zudem so angeordnet, dass ihre Leiterseitenkanten 15 paarweise parallel zueinander ausgerichtet sind, wobei die Leiterseitenkanten 15 in einer Richtung senkrecht zur Erstreckung der Leiterplatten 2a, 2b, 2c zueinander fluchtend oder versetzt zueinander angeordnet sind.

Des Weiteren bestehen die Leiterplatten 2a, 2b, 2c aus elektrisch isolierendem Material, vorzugsweise aus Epoxidharz mit Glasfasergewebe, z. B. FR4 oder FR5, und/oder Keramik und/oder PTFE (Polytetrafluorethylen), letzteres ist bspw. unter dem Handelsnamen Teflon bekannt.

Zudem weist die mittlere Leiterplatte 2b des Leiterplattenstapels 1 eine erste und eine zweite von der Leiterplattenoberseite 3 zur Leiterplattenunterseite 4 durchgehende Durchkontaktierung (Plated Through Hole - PTH) 5, 6 auf. Die beiden Durchkontaktierungen 5, 6 sind zweckmäßigerweise im Kantenbereich der mittleren Leiterplatte 2b und versetzt zueinander angeordnet. Bei den durchgehenden Durchkontaktierungen 5, 6 handelt es sich jeweils um eine Durchgangsbohrung 7, die an ihrer Innenfläche eine Metallbeschichtung bzw. Metallisierung 8 aufweist. An der Leiterplattenoberseite 3 und der Leiterplattenunterseite 4 mündet die Metallisierung 8 jeweils in ein, vorzugsweise ringförmiges, Durchkontaktierungspad 9 der Durchkontaktierung 5, 6 und ist mit diesem elektrisch leitend verbunden. Das Durchkontaktierungspad 9 umgibt also die Durchgangsbohrung 6 auf der Leiterplattenoberseite 3 bzw. der Leiterplattenunterseite 4. Es steht zudem zweckmäßigerweise mit zumindest einer von der Durchkontaktierung 5, 6 wegführenden Leiterbahn 10 in elektrisch leitender Verbindung. Vorzugsweise ist je eine Leiterbahn 10 vorgesehen, die die beiden auf der Leiterplattenoberseite 3 und die beiden auf der Leiterplattenunterseite 4 der mittleren Leiterplatte 2b angeordneten Durchkontaktierungspads 9 der ersten Durchkontaktierung 5 und der zweiten Durchkontaktierung 6 miteinander elektrisch leitend verbindet.

Des Weiteren weist die obere, zur mittleren Leiterplatte 2b benachbarte, Leiterplatte 2a des aus drei Leiterplatten 2a, 2b, 2c bestehenden Leiterplattenstapels 1 an ihrer Leiterplattenunterseite 4, also an der der mittleren Leiterplatte 2b zugewandten Leiterplattenseite, ein einfaches, vorzugsweise durchgehendes, also nicht durch eine Durchkontaktierung 5, 6 unterbrochenes, Lötpad 11 auf. Die untere, ebenfalls zur mittleren Leiterplatte 2b benachbarte, Leiterplatte 2c weist ein derartiges Lötpad 12 an ihrer Leiterplattenoberseite 3, also ebenfalls an ihrer der mittleren Leiterplatte 2b zugewandten Leiterplattenseite, auf. Von den Lötpads 11, 12 führen Leiterbahnen 10 zu Bauteilen oder weiteren Durchkontaktierungen, etc. der Leiterplatten 2a, 2b weg (nicht dargestellt). Zudem weisen die Lötpads 11, 12 zweckmäßigerweise einen rechteckigen Umriss auf.

Die mittlere Leiterplatte 2b ist so angeordnet, dass die erste Durchkontaktierung 5 zum Lötpad 11 der oberen Leiterplatte 2a in einer Richtung senkrecht zur flächenmäßigen Erstreckung der Leiterplatten 2a, 2b, 2c fluchtend und zu diesem gegenüberliegend angeordnet ist, wobei das Lötpad 11 der oberen Leiterplatte 2a und die erste Durchkontaktierung 5 mittels dazwischen vorgesehenem Lot 13 miteinander verlötet sind. Die beiden miteinander zu verbindenden Leiterplatten 2a, 2b sind also im Bereich der Lötverbindung 14 in einer Richtung senkrecht zur flächenmäßigen Erstreckung der Leiterplatten 2a, 2b, 2c zueinander fluchtend angeordnet, wobei zweckmäßigerweise die Leiterplattenseitenkante 15 der mittleren Leiterplatte 2b, in deren Bereich die Durchkontaktierungen 5, 6 vorgesehen sind, etwas ins Innere des Leiterplattenstapels 1 versetzt angeordnet ist. Die Lötverbindung 14 besteht dabei vorwiegend zwischen dem Durchkontaktierungspad 9 der ersten Durchkontaktierung 5 und dem Lötpad 11. Je nach der verwendeten Menge an Lot 13 kann etwas Lot 13 aber auch in die Durchkontaktierung 5 eindringen, so dass auch die Metallisierung 8 durch das Lot 13 kontaktiert wird und die löttechnische Verbindung 14 zwischen der Metallisierung 8 und dem Durchkontaktierungspad 9 der Durchkontaktierung 5 und dem Lötpad 11 besteht.

Zudem ist die mittlere Leiterplatte 2b so angeordnet, dass die zweite Durchkontaktierung 6 zum Lötpad 12 der unteren Leiterplatte 2c in einer Richtung senkrecht zur flächenmäßigen Erstreckung der Leiterplatten 2a, 2b, 2c fluchtend und zu diesem gegenüberliegend angeordnet ist, wobei das Lötpad 12 der unteren Leiterplatte 2c und die zweite Durchkontaktierung 6 ebenfalls mittels dazwischen vorgesehenem Lot 13 miteinander verlötet sind. Die beiden miteinander zu verbindenden Leiterplatten 2b, 2c sind also ebenfalls im Bereich der Lötverbindung 14 in einer Richtung senkrecht zur Erstreckung der Leiterplatten 2a, 2b, 2c zueinander fluchtend angeordnet. Die Lötverbindung 14 besteht auch hier vorwiegend zwischen dem Durchkontaktierungspad 9 der ersten Durchkontaktierung 5 und dem Lötpad 11. Aber auch hier kann die Metallisierung 8 ebenfalls kontaktiert bzw. verlötet sein.

Dabei ist die erste Durchkontaktierung 5 gemäß der Erfindung zur Leiterplattenunterseite 4 der mittleren Leiterplatte 2b hin offen und die zweite Durchkontaktierung 6 ist zur Leiterplattenoberseite 4 der mittleren Leiterplatte 2b hin offen.

Dadurch wird erreicht, dass zuviel vorhandenes Lot 13 in den Durchkontaktierungen 5, 6 aufgenommen werden kann und es zu keinem Kurzschluss mit anderen Verbindungen kommt. Es besteht damit auch nicht mehr die Gefahr, zu wenig Lot 13 zu verwenden, da das Verwenden von zu viel Lot 13 unproblematisch ist, und man einfach etwas mehr Lot 13 verwenden kann, um sicher zu gehen, dass eine bruchsichere Lötverbindung 14 erhalten wird. Dadurch, dass die Durchkontaktierungen 5, 6 auf der der Lötverbindung 14 gegenüberliegenden Leiterplattenseite 3, 4 hin offen sind, wird zudem gewährleistet, dass keine Luft oder sonstige Gase in den Durchkontaktierungen 5, 6 eingeschlossen werden und durch die Erwärmung beim Verlöten das Lot 13 verdrängt.

Das Herstellen der erfindungsgemäßen Leiterplattenstapel 1 ist zudem sehr kostengünstig, da herkömmliche, mit Durchkontaktierungen 5, 6 versehene Leiterplatten 2a, 2b, 2c verwendet werden können. Die Leiterplatten 2a, 2b, 2c können je nach Anwendungszweck auf ihren Leiterplattenober- und -unterseiten 3, 4 weitere Leiterbahnen 10, Lötpads 11, 12, unterschiedliche Arten von Durchkontaktierungen und elektronische Bauteile aufweisen (nicht dargestellt). Zudem ist vorzugsweise Lötstoplack 16 auf die freiliegenden Leiterbahnen 10 und Pads 9, 11, 12 aufgebracht.

Gemäß einer weiteren Ausführungsform der Erfindung (nicht dargestellt) weisen die obere und die untere Leiterplatte 2a, 2c oder eine von beiden anstelle der einfachen, durchgehenden Lötpads 11, 12 blind vias" auf, da es ausreicht, wenn das Lot 13 zu einer Seite hin abfließen kann. "Blind vias" sind innenseitig metallisierte Sacklöcher, die nicht vollständig durch die Leiterplatte durchgehen und jeweils auf der Ober- oder Unterseite 3, 4 einer Leiterplatte 2a, 2c beginnen und ebenfalls ein Durchkontaktierungspad 9 aufweisen. Das "blind via" ist also zu der der Lötverbindung 14 gegenüberliegenden Seite hin geschlossen ausgeführt.

Möglich ist zudem, dass die Lötverbindung 14 der zu verbindenden Leiterplatten 2a, 2b, 2c zwischen einer Durchkontaktierung 5, 6 und einer Leiterbahn 10 besteht. Denn sowohl die Leiterbahnen 10 als auch die Lötpads 11, 12 und das Durchkontaktierungspad 9 sind Metallisierungen bzw. Metallbeschichtungen, die an der Leiterplattenunterseite 4 und der Leiterplattenoberseite 3 oberflächig aufgebracht sind und die Lötverbindung 14 kann zwischen einer Durchkontaktierung 5, 6 der einen Leiterplatte 2b einerseits und jeglicher Art von solchen Metallbeschichtungen der anderen Leiterplatte 2a, 2c bestehen.

Nach einer weiteren Ausführungsform der Erfindung (nicht dargestellt) sind die beiden zu verbindenden Leiterplatten 2a, 2b, 2c mittels mehrerer, flächenmäßig verteilter, erfindungsgemäßer Lötverbindungen 14 miteinander verbunden.

## Patentansprüche

1. Leiterplattenstapel (1) bestehend aus drei parallel zueinander und zumindest bereichsweise übereinander angeordneten Leiterplatten (2a; 2b; 2c), nämlich einer oberen Leiterplatte (2a), einer unteren Leiterplatte (2c) und einer zwischen diesen angeordneten mittleren Leiterplatte (2b), wobei jeweils zwei benachbarte Leiterplatten (2a; 2b; 2c) mittels zumindest einer Lötverbindung (14) miteinander elektrisch und mechanisch in Verbindung stehen,
**dadurch gekennzeichnet, dass**
die mittlere Leiterplatte (2b) eine erste und eine zweite durchgehende Durchkontaktierung (5; 6) aufweist, wobei die Lötverbindung (14) zwischen der oberen Leiterplatte (2a) und der mittleren Leiterplatte (2b) zwischen einer auf einer Leiterplattenunterseite (4) der oberen Leiterplatte (2a) vorgesehenen Metallbeschichtung (9; 10; 11) und der ersten durchgehenden Durchkontaktierung (5) der mittleren Leiterplatte (2b) und die Lötverbindung (14) zwischen der unteren Leiterplatte (2c) und der mittleren Leiterplatte (2b) zwischen einer auf einer Leiterplattenoberoberseite (3) der unteren Leiterplatte (2c) vorgesehenen Metallbeschichtung (9; 10; 12) und der zweiten durchgehenden Durchkontaktierung (5; 6) der mittleren Leiterplatte (2b) besteht, wobei die beiden Durchkontaktierungen (5; 6) zu einer der Lötverbindung (14) gegenüberliegenden Leiterplattenseite (3; 4) der mittleren Leiterplatte (2b) hin jeweils offen sind und wobei es sich bei den Metallbeschichtungen (9; 10; 11; 12) um ein Durchkontaktierungspad (9) einer als innenseitig metallisiertes Sackloch ausgeführten Durchkontaktierung oder eine Leiterbahn (10) oder ein durchgehendes, nicht durch eine Durchkontaktierung unterbrochenes Pad (11; 12) handelt.

2. Leiterplattenstapel nach Anspruch 1,
**dadurch gekennzeichnet, dass**
das durchgehende Pad (11; 12) oder das Durchkontaktierungspad (9) einer als innenseitig metallisiertes Sackloch ausgeführten Durchkontaktierung oder die Leiterbahn (10) der oberen und/oder der unteren Leiterplatte (2a; 2c) und die Durchkontaktierung (5; 6) mittels dazwischen vorgesehenem Lot (13) miteinander verlötet sind.

3. Leiterplattenstapel nach Anspruch 1 und/oder 2,
**dadurch gekennzeichnet, dass**
das durchgehende Pad (11; 12) oder das Durchkontaktierungspad (9) einer als innenseitig metallisiertes Sackloch ausgeführten Durchkontaktierung oder die Leiterbahn (10) der oberen und/oder unteren Leiterplatte (2a; 2c) und die Durchkontaktierung (5; 6) in einer Richtung senkrecht zur flächenmäßigen Erstreckung der Leiterplatten (2a; 2b; 2c) zueinander fluchtend und sich gegenüberliegend angeordnet sind.

4. Leiterplattenstapel nach einem oder mehreren der Ansprüche 1 bis 3,
**dadurch gekennzeichnet, dass**
die beiden durchgehenden Durchkontaktierungen (5; 6) jeweils eine Durchgangsbohrung (7) aufweisen, die an ihrer Innenfläche eine Metallisierung (8) und an einer Leiterplattenoberseite (3) und einer Leiterplattenunterseite (4) je ein Durchkontaktierungspad (9) aufweist, mit dem die Metallisierung (8) elektrisch leitend verbunden ist, wobei das Durchkontaktierungspad (9) die Durchgangsbohrung (6) umgibt.

5. Leiterplattenstapel nach Anspruch 4,
**dadurch gekennzeichnet, dass**
die Lötverbindung (14) zwischen dem jeweiligen Durchkontaktierungspad (9) der durchgehenden Durchkontaktierungen (5; 6) und dem jeweiligen durchgehenden Pad (11; 12) oder dem Durchkontaktierungspad (9) einer als innenseitig metallisiertes Sackloch ausgeführten Durchkontaktierung oder der Leiterbahn (10) besteht.

6. Leiterplattenstapel nach Anspruch 5,
**dadurch gekennzeichnet, dass**
die Lötverbindung (14) zusätzlich zwischen der Metallisierung (8) der durchgehenden Durchkontaktierung (5; 6) und dem jeweiligen durchgehenden Pad (11; 12) oder dem Durchkontaktierungspad (9) einer als innenseitig metallisiertes Sackloch ausgeführten Durchkontaktierung oder der Leiterbahn (10) besteht.

7. Leiterplattenstapel nach einem oder mehreren der Ansprüche 1 bis 6,
**dadurch gekennzeichnet, dass**
die Leiterplatten (2a, 2b, 2c) quaderförmig ausgebildet sind und je die Leiterplattenoberseite (3) und die dazu parallele Leiterplattenunterseite (4), sowie vier paarweise zueinander und zur Leiterplattenoberseite (3) senkrechte Leiterplattenseitenkanten (15) aufweisen.

8. Leiterplattenstapel nach Anspruch 7,
**dadurch gekennzeichnet, dass**
die beiden durchgehenden Durchkontaktierungen (5; 6) im Kantenbereich der mittleren Leiterplatte (2b) und versetzt zueinander angeordnet sind.

9. Leiterplattenstapel nach Anspruch 7 und/oder 8,
**dadurch gekennzeichnet, dass**
die Leiterplattenseitenkante (15) der mittleren Leiterplatte (2b), in deren Bereich die durchgehenden Durchkontaktierungen (5; 6) vorgesehen sind, etwas ins Innere des Leiterplattenstapels (1) versetzt angeordnet ist.

## Claims

1. Printed circuit board stack (1) comprising three printed circuit boards (2a; 2b; 2c) arranged parallel to one another and one above another at least in regions, namely an upper printed circuit board (2a), a lower printed circuit board (2c) and a central printed circuit board (2b) arranged between them, wherein two adjacent printed circuit boards (2a; 2b; 2c) in each case are electrically and mechanically connected to one another by means of at least one soldering connection (14),
**characterized in that**
the central printed circuit board (2b) has a first and a second continuous plated-through hole (5; 6), wherein the soldering connection (14) between the upper printed circuit board (2a) and the central printed circuit board (2b) exists between a metal coating (9; 10; 11) provided on a printed circuit board under side (4) of the upper printed circuit board (2a) and the first continuous plated-through hole (5) of the central printed circuit board (2b) and the soldering connection (14) between the lower printed circuit board (2c) and the central printed circuit board (2b) exists between a metal coating (9; 10; 12) provided on a printed circuit board top side (3) of the lower printed circuit board (2c) and the second continuous plated-through hole (5; 6) of the central printed circuit board (2b), wherein the two plated-through holes (5; 6) are in each case open towards a printed circuit board side (3; 4) of the central printed circuit board (2b) that is opposite relative to the soldering connection (14), and wherein the metal coatings (9; 10; 11; 12) are a plated-through hole pad (9) of a plated-through hole embodied as a blind hole metallized on the inside or a conductor track (10) or a continuous pad (11; 12) not interrupted by a plated-through hole.

2. Printed circuit board stack according to Claim 1,
**characterized in that**
the continuous pad (11; 12) or the plated-through hole pad (9) of a plated-through hole embodied as a blind hole metallized on the inside or the conductor track (10) of the upper and/or lower printed circuit board (2a; 2c) and the plated-through hole (5; 6) are soldered to one another by means of solder (13) provided therebetween.

3. Printed circuit board stack according to Claim 1 and/or Claim 2,
**characterized in that**
the continuous pad (11; 12) or the plated-through hole pad (9) of a plated-through hole embodied as a blind hole metallized on the inside or the conductor track (10) of the upper and/or lower printed circuit board (2a; 2c) and the plated-through hole (5; 6) are arranged in alignment and opposite relative to one another in a direction perpendicular to the areal extent of the printed circuit boards (2a; 2b; 2c).

4. Printed circuit board stack according to one or more of Claims 1 to 3,
**characterized in that**
the two continuous plated-through holes (5; 6) in each case have a through hole (7) having a metallization (8) on its inner surface and a respective plated-through hole pad (9) on a printed circuit board top side (3) and a printed circuit board under side (4), the metallization (8) being electrically conductively connected to said plated-through hole pad, wherein the plated-through hole pad (9) surrounds the through hole (6).

5. Printed circuit board stack according to Claim 4,
**characterized in that**
the soldering connection (14) exists between the respective plated-through hole pad (9) of the continuous plated-through holes (5; 6) and the respective continuous pad (11; 12) or the plated-through hole pad (9) of a plated-through hole embodied as a blind hole metallized on the inside or the conductor track (10).

6. Printed circuit board stack according to Claim 5,
**characterized in that**
the soldering connection (14) additionally exists between the metallization (8) of the continuous plated-through hole (5; 6) and the respective continuous pad (11; 12) or the plated-through hole pad (9) of a plated-through hole embodied as a blind hole metallized on the inside or the conductor track (10).

7. Printed circuit board stack according to one or more of Claims 1 to 6,
**characterized in that**
the printed circuit boards (2a, 2b, 2c) are embodied in a parallelepipedal fashion and each have the printed circuit board top side (3) and the printed circuit board under side (4) parallel thereto, and also four printed circuit board side edges (15) perpendicular to one another and to the printed circuit board top side (3) in pairs.

8. Printed circuit board stack according to Claim 7,
**characterized in that**
the two continuous plated-through holes (5; 6) are arranged in the edge region of the central printed circuit board (2b) and in a manner offset with respect to one another.

9. Printed circuit board stack according to Claim 7 and/or Claim 8,
**characterized in that**
the printed circuit board side edge (15) of the central printed circuit board (2b), in the region of which the continuous plated-through holes (5; 6) are provided, is arranged in a manner offset somewhat into the interior of the printed circuit board stack (1).

## Revendications

1. Empilement de cartes de circuit imprimé (1) constitué de trois cartes de circuit imprimé (2a ; 2b ; 2c) disposées parallèlement l'une à l'autre et au moins par endroits les unes sur les autres, à savoir une carte de circuit imprimé supérieure (2a), une carte de circuit imprimé inférieure (2c) et une carte de circuit imprimé intermédiaire (2b) disposée entre celles-ci, dans lequel deux cartes de circuit imprimé voisines (2a ; 2b ; 2c) sont respectivement électriquement et mécaniquement reliées l'une à l'autre au moyen d'au moins une liaison par brasage (14),
**caractérisé en ce que** la carte de circuit imprimé intermédiaire (2b) comporte des premier et deuxième trous d'interconnexion traversants (5 ; 6), dans lequel la liaison par brasage (14) entre la carte de circuit imprimé supérieure (2a) et la carte de circuit imprimé intermédiaire (2b) est présente entre un revêtement métallique (9 ; 10 ; 11) prévu sur une face inférieure de carte de circuit imprimé (4) de la carte de circuit imprimé supérieure (2a) et le premier trou d'interconnexion traversant (5) de la carte de circuit imprimé intermédiaire (2b), et la liaison par brasage (14) entre la carte de circuit imprimé inférieure (2c) et la carte de circuit imprimé intermédiaire (2b) est présente entre un revêtement métallique (9 ; 10 ; 12) prévu sur une face supérieure de carte de circuit imprimé (3) de la carte de circuit imprimé inférieure (2c) et le deuxième trou d'interconnexion traversant (5 ; 6) de la carte de circuit imprimé intermédiaire (2b), dans lequel les deux trous d'interconnexion (5 ; 6) sont respectivement ouverts vers une face de carte de circuit imprimé (3 ; 4) de la carte de circuit imprimé intermédiaire (2b), opposée à la liaison par brasage (14), et dans lequel les revêtements métalliques (9 ; 10 ; 11 ; 12) sont un plot d'interconnexion (9) d'un trou d'interconnexion réalisé sous la forme d'un trou borgne métallisé du côté interne ou une piste conductrice (10) ou un plot traversant (11 ; 12) non interrompu par un trou d'interconnexion.

2. Empilement de cartes de circuit imprimé selon la revendication 1,
**caractérisé en ce que** le plot traversant (11 ; 12) ou le plot d'interconnexion (9) d'un trou d'interconnexion réalisé sous la forme d'un trou borgne métallisé du côté interne ou la piste conductrice (10) de la carte de circuit imprimé (2a ; 2c) supérieure et/ou inférieure et le trou d'interconnexion (5 ; 6) sont brasés les uns aux autres par de la brasure (13) disposée entre ceux-ci.

3. Empilement de cartes de circuit imprimé selon la revendication 1 et/ou 2, **caractérisé en ce que** le plot traversant (11 ; 12) ou le plot d'interconnexion (9) d'un trou d'interconnexion réalisé sous la forme d'un trou borgne métallisé du côté interne ou la piste conductrice (10) de la carte de circuit imprimé supérieure et/ou inférieure (2a ; 2c) et le trou d'interconnexion (5 ; 6) sont disposés en alignement les uns par rapport aux autres et en position opposée dans une direction perpendiculaire à l'extension superficielle des cartes de circuit imprimé (2a ; 2b ; 2c).

4. Empilement de cartes de circuit imprimé selon une ou plusieurs des revendications 1 à 3, **caractérisé en ce que** les deux trous d'interconnexion traversants (5 ; 6) comportent respectivement un trou traversant (7) qui présente sur sa surface interne une métallisation (8) et un plot d'interconnexion (9) respectif sur une face supérieure (3) de la carte de circuit imprimé et sur une face inférieure de carte de circuit imprimé (4), auquel la métallisation (8) est reliée de manière électriquement conductrice, dans lequel le plot d'interconnexion (9) entoure le trou traversant (6).

5. Empilement de cartes de circuit imprimé selon la revendication 4, **caractérisé en ce que** la liaison par brasage (14) est présente entre le plot d'interconnexion (9) respectif des trous d'interconnexion traversants (5 ; 6) et le plot traversant (11 ; 12) respectif ou le plot d'interconnexion (9) d'un trou d'interconnexion réalisé sous la forme d'un trou borgne métallisé du côté interne ou la piste conductrice (10).

6. Empilement de cartes de circuit imprimé selon la revendication 5, **caractérisé en ce que** la liaison par brasage (14) est en outre présente entre la métallisation (8) des trous d'interconnexion traversants (5 ; 6) et le plot traversant (11 ; 12) respectif ou le plot d'interconnexion (9) d'un trou d'interconnexion réalisé sous la forme d'un trou borgne métallisé du côté interne ou la piste conductrice (10).

7. Empilement de cartes de circuit imprimé selon une ou plusieurs des revendications 1 à 6, **caractérisé en ce que** les cartes de circuit imprimé (2a, 2b, 2c) sont réalisées de manière parallélépipédique et **en ce que** la face supérieure (3) de la carte de circuit imprimé et la face inférieure de carte de circuit imprimé (4) parallèle à celle-ci comportent chacune également quatre bords latéraux de carte de circuit imprimé (15) perpendiculaires par paires l'un à l'autre et à la face supérieure (3) de la carte de circuit imprimé.

8. Empilement de cartes de circuit imprimé selon la revendication 7, **caractérisé en ce que** les deux trous d'interconnexion traversants (5 ; 6) sont disposés dans la région des bords de la carte de circuit imprimé intermédiaire (2b) et de manière décalée l'un par rapport à l'autre.

9. Empilement de cartes de circuit imprimé selon la revendication 7 et/ou 8, **caractérisé en ce que** le bord latéral de carte de circuit imprimé (15) de la carte de circuit imprimé intermédiaire (2b) dans la région de laquelle se trouvent les trous d'interconnexion traversants (5 ; 6) est disposé de manière légèrement décalée à l'intérieur de l'empilement de cartes de circuit imprimé (1).
